# EUROPEAN PATENT SPECIFICATION

(11) **EP 4 528 817 B1**
(45) Date of publication and mention of the grant of the patent: **14.01.2026**
(21) Application number: 23198389.1
(22) Date of filing: 19.09.2023
(51) Int. Cl.: H10F 39/12, H04N 25/00

(54) **PHASE DETECTION AUTOFOCUS PIXEL**
PHASENDETEKTIONSAUTOFOKUSPIXEL
PIXEL DE MISE AU POINT AUTOMATIQUE À DÉTECTION DE PHASE

(43) Date of publication of application: 26.03.2025
(73) Proprietor: Gpixel NV, 2018 Antwerpen (BE)
(72) Inventor: BOGAERTS, Jan, 2860 Sint-Katelijne-Waver (BE); BOULENC, Pierre, 76290 Montivilliers (FR)
(74) Representative: Winger

(56) References cited:
- US-A1- 2019 297 291
- US-A1- 2021 105 423
- US-A1- 2022 028 912

## Description

### Technical field of the invention

The present invention relates to the field of phase detection autofocus pixels.

### Background of the invention

Phase detection autofocus (PDAF) pixels are commonly used in CMOS image sensors (CIS). PDAF pixels allow to measure directly the amount of (de-)focus, and, if defocused, the direction (front-focus, rear-focus) of the defocus. A lens of a camera can, therefore, quickly be adjusted to bring the image into focus. PDAF pixels allow for a much faster focusing than, for example, when contrast autofocus is applied.

Documents US 2021/105423 A1, US 2022/028912 A1 and US 2019/297291 A1 show phase detection autofocus pixel arrays according to the prior-art.

Reference is made to FIG. 1A, corresponding to FIG. 17 of US6829008B1, which shows an image sensor 61 of a camera comprising a plurality of PDAF pixels 9. In the state of the art, each PDAF pixel 9 contains a single microlens 93. For illustrative purposes, in this example, each PDAF pixel 9 contains a first photodiode S1 and a second photodiode S2, offset in opposite directions, namely in the direction -X and X respectively, with respect to the optical axis 95 of the microlens 93 of the PDAF pixel 9. The camera further comprises a camera lens 5.

In the following, it is described how the PDAF pixels 9 can be used to determine whether the camera is focused. Herein, an idealized functioning of the PDAF pixels 9 is assumed, ignoring limited focusing capabilities of the microlenses, which will subsequently be described.

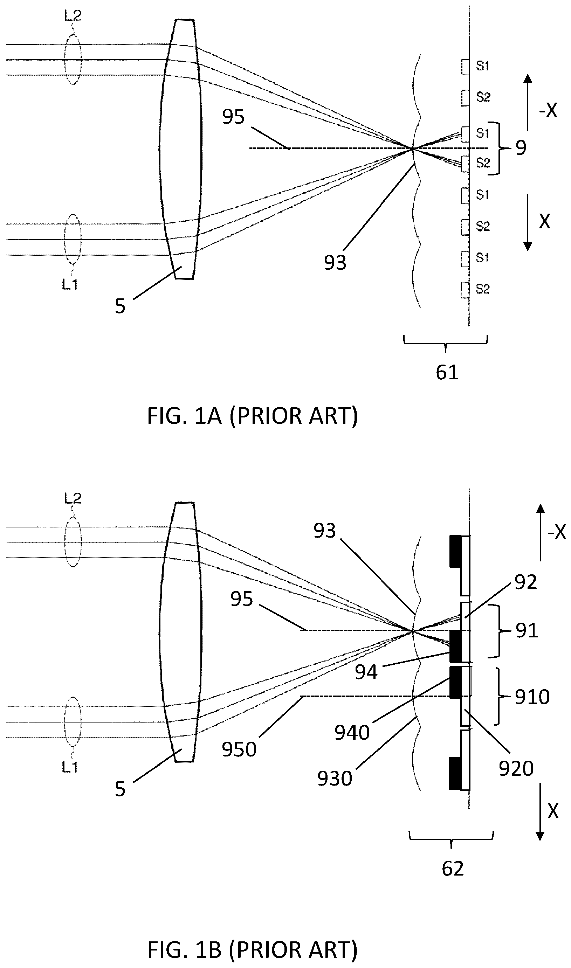

Light from each specific point on an object (the object is not shown) that is collected by the camera lens 5 may be assumed to be split into a first light beam L1 and a second light beam L2. For simplicity, in FIG. 1A, light collected by the camera lens 5 from only a single specific point on the object is shown. The first light beam L1 propagates through a first half of the camera lens 5, then through a microlens 93 of one of the PDAF pixels 9, and is incident on the first photodiode S1 of that PDAF pixel 9. The second light beam L2 propagates through a second half of the camera lens 5, then through a microlens 93 of one of the PDAF pixels 9, and is incident on the second photodiode S2 of that PDAF pixel 9.

When the camera is in-focus on the object, as is the case in FIG. 1A, the camera lens 5 focuses light from each point on the object onto the microlenses 93 of the image sensor 61, thereby generating an image of the object in the plane of the microlenses 93. As such, when the camera is in focus, the two light beams L1 and L2 from each specific point on the object are focused on a single point on the microlens 93 of a single PDAF pixel 9. As a result, when in focus, the first photodiode S1 detecting the first light beam L1 from the specific point on the object is located in the same PDAF pixel 9 as the second photodiode S2 detecting the second light beam L2 from the specific point on the object. As a consequence, when in focus, a first image of the object, formed by the L1 light beam, that is detected by the first photodiodes S1 of the image sensor 61 and a second image of the object, formed by the L2 light beam, that is detected by the second photodiodes S2 of the image sensor 61, coincide on the same pixel.

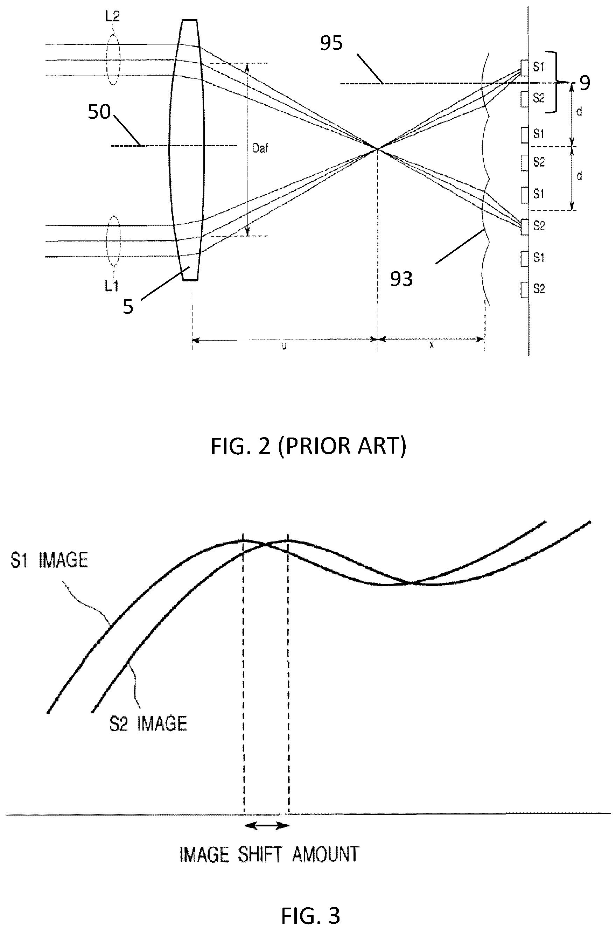

FIG. 2 corresponds to FIG. 17 of US6829008B1 and shows the situation wherein the camera is out of focus, more particularly, in front-focus. As shown in FIG. 2, when out of focus, the first light beam L1 and the second light beam L2 from each specific point on the object cross each other at a position away from the plane of the microlenses 93. Therefore, when out of focus, for light beams L1 and L2 from each specific point on the object, the first light beam L1 and the second light beam L2 are incident on different microlenses 93, so that the first photodiode S1 detecting the first light beam L1 is located in a different PDAF pixel 9 than the second photodiode S2 detecting the second light beam L2. As a consequence, as may be observed in FIG. 3, corresponding to FIG. 19 of US6829008B1, when out of focus, a first image ("S1 image") of the object detected by the first photodiodes S1 of the image sensor 61 is shifted with respect to a second image ("S2 image") of the object detected by the second photodiodes S2 of the image sensor 61. As is further explained in US6829008B1, the magnitude of this shift can be directly related to the distance between the point where the first light beam L1 and the second light beam L2 from the specific point on the object cross, and the plane of the microlenses 93, providing a direct way for determining the distance that the camera lens 5 has to be translated along the optical axis 50 of the camera lens 5 to bring the camera in focus with the object.

Reference is made to FIG. 1B. Although above, for illustrative purposes, each PDAF pixel contained two photodiodes (i.e., the first photodiode S1 and the second photodiode S2), in practice, a single pixel 91, 910 typically contains only a single photodiode 92, 920. Therefore, in practice, a single PDAF pixel 91, 910 cannot detect the first light beam L1 and the second light beam L2 independently from one another. This problem is solved in the art by using pairs of PDAF pixels 91 and 910. Each pair contains a first PDAF pixel 91 for detecting the first light beam L1, which contains a microlens 93 and a light shield 94, offset in a first offset direction X with respect to the optical axis 95 of the microlens 93, covering half of the photodiode 92 of the first PDAF pixel 91 at the side of the optical axis 95 in the first offset direction X, for blocking the second light beam L2. Each pair further contains a second PDAF pixel 910 for detecting the second light beam L2, which contains a microlens 930 and a light shield 940, offset in a second offset direction -X, opposite to the first offset direction X, with respect to the optical axis 950 of the microlens 930, covering half of the photodiode 920 of the second PDAF pixel 910 at the side of the optical axis 950 in the second offset direction -X, for blocking the first light beam L1. Thereby, the first PDAF pixels 91 of the image sensor 62 substantially detect the first image as correspondingly measured by the first photodiodes S1 in the illustrative example of FIG. 1A and FIG. 2 (i.e., "S1 image" in FIG. 3), while the second PDAF pixels 910 of the image sensor 62 substantially detect the second image as correspondingly measured by the second photodiodes S2 in the illustrative example of FIG. 1A and FIG. 2 (i.e., "S2 image" in FIG. 3). Of course, as for each specific point on the object, now, only the first light beam L1 or the second light beam L2 is measured, there is a slight reduction of the resolution of the images.

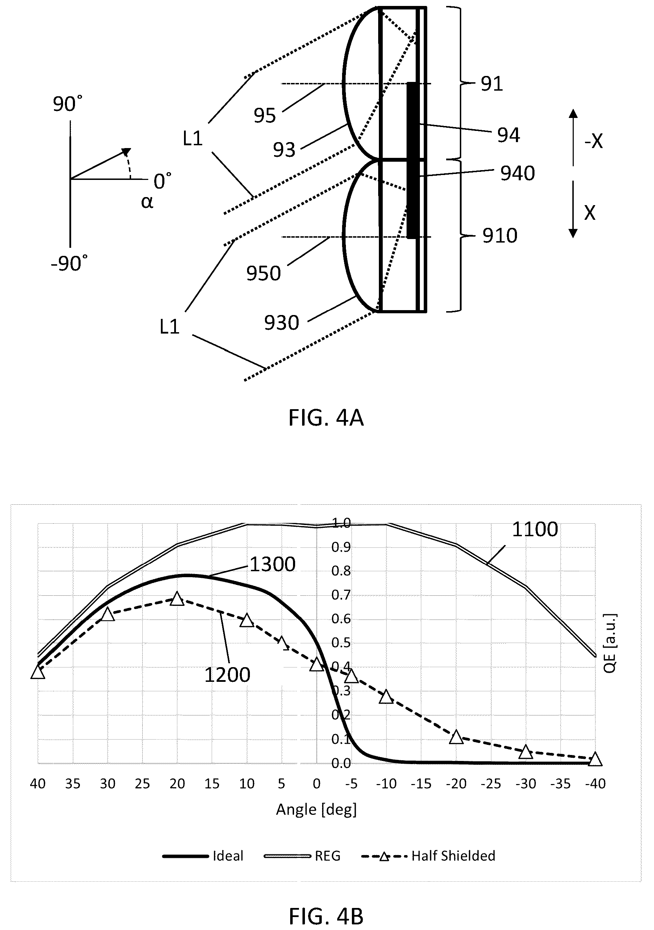

Reference is made to FIG. 4A, showing a first PDAF pixel 91 and a second PDAF pixel 910, on which different light beams (corresponding to first light beams L1 from different, neighboring locations on the object, propagating through the first halve of the camera lens), having the same particular angle of incidence α, are incident. The plot on the left indicates the orientation of the angle of incidence α for light incident on the microlenses 93, 930. Herein, the angle of incidence α is in a plane parallel to the optical axes 95, 950 of the microlenses 93, 930 and parallel to the X-axis (along which the light shields 94, 940 are shifted from the optical axes 95, 950 of the respective PDAF pixels 91, 910), and is with respect to normal incidence, which is along the optical axes 95, 950 of the microlenses 93, 930. Herein, a direction for incident light that has an X-component pointing in the direction of X has a negative angle of incidence α, and a direction of incident light that has an X-component pointing in the direction of -X has a positive angle of incidence α.

The above described idealized functioning of the PDAF pixels 91, 910, without intra-pixel cross-talk, implies a perfect selectivity of the first PDAF pixels 91 towards the first light beams L1 and of the second PDAF pixels towards the second light beams L2. This is achieved when the first PDAF pixel 91 detects all light beams having a positive angle of incidence α (i.e., first light beams L1) while its light shield 94 blocks all light having a negative angle of incidence α (i.e., second light beams L2), and the second PDAF pixel 910 detects all light beams having a negative angle of incidence α while its light shield 940 blocks all light having a positive angle of incidence α. Such a good selectivity may be achieved when, amongst others, each microlens 93, 930 sharply focuses light from each angle of incidence α in the plane of the light shields 94, 940, as is shown in FIG. 4A, with light collected by each microlens 93, 930 having a negative or positive angle of incidence α being focused in the first direction X or the second direction -X, respectively, with respect to the optical axis 95, 950.

Reference is made to FIG. 4B, which shows the quantum efficiency (QE), as a function of the angle of incidence α for a regular (non-PDAF) pixel (indicated by 1100), for a structurally non-optimized PDAF pixel (indicated by 1200), and for a structurally well-optimized second PDAF pixel (indicated by 1300).

Such a good focus in the plane, and correspondingly, such a good selectivity can be observed for the structurally well-optimized second PDAF pixel (indicated by 1300), which senses light having a negative angle of incidence but barely detects any light having a positive angle of incidence. In practice, such a sharp focus in the plane of the light shields is often difficult to achieve, for example, because the microlenses are structurally not well-optimized. As a result, as may be observed for the structurally non-optimized PDAF pixels (indicated by 1200), the second PDAF pixel exhibits limited focusing capabilities of the microlens, meaning that, unwantedly, the second PDAF pixel does detect a substantial part of the light having a positive angle of incidence (i.e., the first light beams L1) while a substantial part of the light having a negative angle of incidence (i.e., the second light beams L2) is blocked by the light shield, thereby reducing its sensitivity and accuracy. Such limited focusing capability is, of course, correspondingly exhibited by first PDAF pixels. The more limited focusing capability exhibited by the microlens of the PDAF pixels, the more the shape of the curve would reminisce that of the regular pixel (indicated by 1100) which, of course, does not exhibit any selectivity towards positive or negative angles of incidence. As a result of the limited focusing capabilities of the microlens, the contrast between the first and second image as detected by the first and second PDAF pixels, respectively, is reduced, in turn resulting in a reduction in the accuracy of the autofocusing.

This limited focusing capability of the microlens may be particularly problematic for image sensors containing large pixels, for which process capabilities are limited with respect to the shape, material, and height of the microlenses, and the height of color filters and clear planarization layers. For example, for large pixels, the height and radius of curvature of the microlenses may become so large that known manufacturing techniques do not result in well-formed microlenses. Consequently, for large pixels, sharp focusing of light from each angle of incidence by the microlenses in the plane of the light shields is particularly difficult to obtain.

There is thus still a need in the art for devices and methods that address at least some of the above problems.

### Summary of the invention

It is an object of embodiments of the present invention to provide a good phase detection autofocus pixel. It is a further object of embodiments of the present invention to provide a good image sensor comprising a pair of said phase detection autofocus pixels. It is still a further object of embodiments of the present invention to provide a good camera comprising the image sensor.

It is an object of embodiments of the present invention to provide a good use of the phase detection autofocus pixel for focusing of a camera lens.

The above objectives are accomplished by methods and devices according to embodiments of the present invention.

It is an advantage of embodiments of the present invention that the consequences of the limited focussing capabilities of the microlenses may be limited. It is an advantage of embodiments of the present invention that a good contrast may be obtained between a first image produced by first phase detection autofocus pixels and a second image produced by second phase detection autofocus pixels of pairs of phase detection autofocus pixels. Thereby, a good quality of the phase detection autofocus functionality may be achieved.

In a first aspect, the present invention relates to a phase detection autofocus pixel. The phase detection autofocus pixel comprises a photodiode, and a plurality of microlenses for concentrating light, incident on each of the microlenses, onto the photodiode. The phase detection autofocus pixel further comprises, for each microlens, a light shield associated therewith, for blocking part of the light transmitted by the microlens towards the photodiode. The light shields are offset from an optical axis of their associated microlenses in a same offset direction. The light shields may have vertical and horizontal edges, but also slanted edges are possible. It is an advantage of embodiments of the present invention that, in particular for large pixels, instead of using a single large microlens per pixel as in the state of the art, for which the height and radius of curvature of the microlens may become so large that known manufacturing techniques do not result in well-formed microlenses, multiple smaller lenses may be used of a size for which manufacturing techniques have been optimized.

The microlenses may be organised in any way, e.g., in an array. For example, the array may comprise NxM microlenses per pixel, wherein N and M are integers that may be the same or different. In preferred embodiments, the plurality of microlenses are organised in a square array. In other words, the phase detection autofocus pixel may comprise NxN microlenses, wherein N is an integer. Such a regular pattern may result in relatively easy manufacturing. In embodiments, the square array of microlenses comprises rows and columns of microlenses, each row and column comprising at least two microlenses (i.e., N is at least 2). For example, the square array may comprise from two to ten (i.e., N is from 2 to 10), or from two to four (i.e., N is from 2 to 4) microlenses in a row and column. In alternative embodiments, in which the microlenses are organised in an array of NxM microlenses per pixel, either N or M could be equal to one, provided the other one of M or N is equal to or larger than two.

In embodiments, the plurality of microlenses are substantially uniform in shape and size. In embodiments, each of the plurality of microlenses may have substantially the same aperture and substantially the same focus distance. Typically, each microlens has a plane surface facing towards the photodiode, and a convex surface facing away from the photodiode. For example, each microlens may be a spherical lens. In practice, microlenses may rather have the shape of a cuboid with rounded corners and edges at a side of the microlens facing away from the photodiode. However, the invention is not limited to any shape of microlens. This shape may typically depend on the manufacturing method.

In embodiments, the light shields may be substantially uniform in shape and size. In embodiments, a distance between each light shield and its associated microlens is substantially the same for the different light shields and associated microlenses. Preferably, each light shield is offset by substantially a same distance from the optical axis of its associated microlens. It is an advantage of these embodiments that interpretation of the detected signal, detected by the photodiode, may be straightforward. Nevertheless, in alternative embodiments, shape, size and/or offset of the light shields may be non-uniform over the different pixels.

In preferred embodiments, the cross-section of each light shield, in the plane of the light shields, is rectangular. However, the invention is not limited thereto and the light shields may have any suitable shape. In preferred embodiments, the light shield associated with a microlens blocks substantially all light transmitted by the associated microlens that would, in absence of the light shield, be collected by the photodiode at a side of the optical axis of the associated microlens in said offset direction. Furthermore, preferably, the light shield substantially does not block light that would, in absence of the light shield, be collected by the photodiode at a side of the optical axis of the associated microlens opposite to said offset direction. It is an advantage of these embodiments that a good sensitivity and angular response of the phase detection autofocus pixel may be achieved.

Each light shield may be formed of any material that may block light. For example, the material may efficiently absorb visible light and/or efficiently reflect visible light. In embodiments, each light shield may be formed of a metal, such as for instance tungsten, aluminium or copper. Metal is, typically, highly reflective and may, therefore, efficiently block light.

In a second aspect, the present invention relates to an image sensor comprising a pair of phase detection autofocus pixels. Said pair comprises a first phase detection autofocus pixel in accordance with embodiments of the first aspect of the present invention, wherein the light shields of the first phase detection autofocus pixel are each offset from the optical axis of their associated microlens in a first direction. Said pair further comprises a second phase detection autofocus pixel in accordance with embodiments of the first aspect of the present invention, wherein the light shields of the second phase detection autofocus pixel are each offset from the optical axis of their associated microlens in a second direction, substantially opposite to the first direction. It is an advantage of embodiments of the present invention that the image sensor may provide good focusing of a camera lens.

Preferably, the first phase detection autofocus pixel and the second phase detection autofocus pixel are located close to each other. Preferably, the first phase detection autofocus pixel and the second phase detection are separated from each other by at most ten pixels, such as at most five pixels, or are directly adjacent to, e.g., in contact with, each other. This may result in a good comparison of the signals of the first and second phase detection autofocus pixel. Typically, the image sensor comprises a plurality of first phase detection autofocus pixels and a plurality of second phase detection autofocus pixels. In other words, the image sensor may comprise a plurality of pairs of phase detection autofocus pixels. In these embodiments, the first and second phase detection autofocus pixels may be substantially evenly distributed within the image sensor.

Although in most cases the analysis of the two signals is done externally to the image sensor, in particular embodiments, the image sensor comprises a device configured for comparing a signal generated by the photodiode of the first phase detection autofocus pixel with a signal generated by the photodiode of the second phase detection autofocus pixel. In embodiments comprising the plurality of pairs, said device may be configured for comparing signals, i.e., a first image, generated by the photodiodes of the plurality of first phase detection autofocus pixels with signals, i.e., a second image, generated by the photodiodes of the plurality of second phase detection autofocus pixels. It is to be noted that the "image" formed by the signals of the PDAF pixels can be composed out of a very limited number of pixels, not necessarily making up an image that would be appreciated as such by the user of a camera containing the pixels.

In addition, the image sensor may comprise at least one further pair, e.g., a plurality of further pairs, of phase detection autofocus pixels, wherein said further pair comprises a third phase detection autofocus pixel in accordance with embodiments of the first aspect of the present invention. In these embodiments, the light shields of the third phase detection autofocus pixel are each offset from the optical axis of their associated microlens in a third direction, substantially perpendicular to the first direction. In these embodiments, said further pair also comprises a fourth phase detection autofocus pixel in accordance with embodiments of the first aspect of the present invention, wherein the light shields of the fourth phase detection autofocus pixel are each offset from the optical axis of their associated microlens in a fourth direction, substantially opposite to the third direction. It is an advantage of these embodiments that a more accurate focusing may be obtained. Features of the third and fourth phase detection autofocus pixels may be independently as correspondingly described for the first and second phase detection autofocus pixels.

In a third aspect, the present invention relates to a camera comprising the image sensor in accordance with embodiments of the second aspect of the present invention comprising the device configured for comparing a signal generated by the photodiode of the first phase detection autofocus pixel with a signal generated by the photodiode of the second phase detection autofocus pixel. The camera further comprises a camera lens. The camera is configured, e.g., comprises suitable means such as an actuator, for moving the camera lens along an optical axis of the camera lens based on said comparing of a signal generated by the photodiode of the first phase detection autofocus pixel with a signal generated by the photodiode of the second phase detection autofocus pixel.

In preferred embodiments, said comparing is performed between signals representing a first image, generated by the photodiodes of a plurality of first phase detection autofocus pixels, with signals representing a second image, generated by the photodiodes of a plurality of second phase detection autofocus pixels. If the first image is detected to be shifted with respect to the second image, the camera lens may be moved so as to coincide the first image with the second image.

Alternatively, the means for moving the camera lens may be configured for reducing, preferably minimising, the difference between the signal from the photodiode of the first phase detection autofocus pixel and the signal generated by the photodiode of the second phase detection autofocus pixel. For example, said comparing may comprise determining whether the signal generated by the photodiode of the first phase detection autofocus pixel of the pair of phase detection autofocus pixels has a pre-defined shift compared to the signal generated by the photodiode of the second phase detection autofocus pixel of the pair of phase detection autofocus pixels. If it is determined that this is not the case, the camera lens may be moved until the signals exhibit that pre-defined shift.

In a fourth aspect, the present invention relates to a use of a phase detection autofocus pixel in accordance with embodiments of the first aspect of the present invention for focusing of a camera lens.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A is a schematic representation of a vertical cross-section of a camera lens and an image sensor comprising phase detection autofocus pixels comprising a first photodiode S1 and a second photodiode S2 in accordance with the prior art, wherein the camera lens focuses light from a point on an object on a microlens of the image sensor.
FIG. 1B is a schematic representation of a vertical cross-section of a camera lens and an image sensor comprising phase detection autofocus pixels comprising light shields in accordance with the prior art, wherein the camera lens focuses light on a microlens of the image sensor.
FIG. 2 is a schematic representation of a vertical cross-section of a camera lens and an image sensor comprising phase detection autofocus pixels comprising a first photodiode S1 and a second photodiode S2 in accordance with the prior art, wherein the camera is out of focus.
FIG. 3 is a plot of images "S1 image" and "S2 image", generated by first and second light beams incident on a plurality of first photodiodes S1 and a plurality of second photodiodes S2, respectively.
FIG. 4A is a schematic representation of a vertical cross-section of a pair of phase detection autofocus pixels in accordance with the prior art, wherein beams of light, having a particular angle of incidence, are incident on the microlenses of the phase detection autofocus pixels. The inset on the left indicates the orientation of the angle of incidence.
FIG. 4B is a plot of the quantum efficiency of a regular (non-PDAF) pixel, of a structurally non-optimized phase detection autofocus pixel in accordance with the prior art, and of a structurally optimized phase detection autofocus pixel in accordance with the prior art, as a function of angle of incidence.
FIG. 5 is a schematic representation of a top view of part of an image sensor in accordance with embodiments of the present invention.
FIG. 6 is a vertical cross-section of part of an image sensor in accordance with embodiments of the present invention.
FIG. 7 is a schematic representation of a vertical cross-section of a camera in accordance with embodiments of the present invention.
FIG. 8 is a graph showing modelling results for a range of phase detection autofocus pixels, including phase detection autofocus pixels of the state of the art, and phase detection autofocus pixels in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims and description, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a phase detection autofocus pixel. The phase detection autofocus pixel comprises a photodiode, and a plurality of microlenses for concentrating light, incident on each of the microlenses, onto the photodiode. The phase detection autofocus pixel further comprises, for each microlens, a light shield associated therewith, for blocking part of the light transmitted by the microlens towards the photodiode. The light shields are offset from an optical axis of their associated microlenses in a same offset direction.

In a second aspect, the present invention relates to an image sensor comprising a pair of phase detection autofocus pixels. Said pair comprises a first phase detection autofocus pixel in accordance with embodiments of the first aspect of the present invention, wherein the light shields of the first phase detection autofocus pixel are each offset from the optical axis of their associated microlens in a first direction. Said pair further comprises a second phase detection autofocus pixel in accordance with embodiments of the first aspect of the present invention, wherein the light shields of the second phase detection autofocus pixel are each offset from the optical axis of their associated microlens in a second direction, substantially opposite to the first direction.

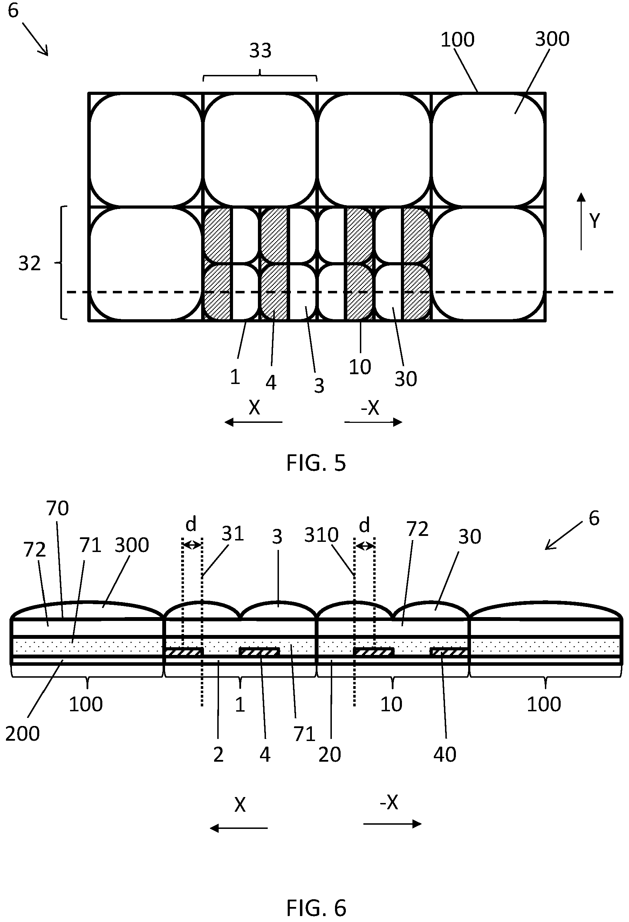

Reference is made to FIG. 5, which is a schematic representation of a top view of a part of an image sensor 6 in accordance with embodiments of the present invention. Simultaneously, reference is made to FIG. 6, which is a schematic representation of a vertical cross-section of the part of the image sensor 6, along the dashed line in FIG. 5. In the example illustrated, the part of the image sensor 6 comprises a plurality of pixels, including two phase detection autofocus pixels 1 and 10 in accordance with embodiments of the present invention, and six regular pixels 100, i.e., pixels that are configured for detecting light for detecting an image but not for performing phase detection autofocus. In the embodiment illustrated, the regular pixels and the PDAF pixels have different size of microlenses. This, however, is not required for the present invention, and all or substantially all microlenses may be equal to one another. Different sizes or shapes of microlenses are possible, but often make the production process more complicated.

Each of the two phase detection autofocus pixels 1, 10 comprises a single photodiode 2, 20. A first phase detection autofocus pixel 1 of the two phase detection autofocus pixels 1, 10 comprises, in the example illustrated, four microlenses 3 for concentrating light, incident on each of the microlenses 3, through a transparent planarization layer 72 and optionally a color filter 71, onto the photodiode 2 of the first phase detection autofocus pixels 1. A second phase detection autofocus pixel 10 of the two phase detection autofocus pixels 1, 10 comprises, in the example illustrated, four microlenses 30 for concentrating light, incident on each of the microlenses 30, through a transparent planarization layer 72 and optionally a color filter 71, onto the photodiode 20 of the second phase detection autofocus pixels 10. Herein, the microlenses 3 and 30 within each phase detection autofocus pixel 1, 10 are ordered in a square array of 2x2 microlenses 3, 30, i.e., the microlenses 3 and 30 are ordered in two rows 32 and two columns 33. In general, each autofocus pixel may comprise a plurality of microlenses ordered in a regular or irregular way, preferably a rectangular array of NxM microlenses, preferably a square array of NxN microlenses.

In the example illustrated, each of the regular pixels 100 comprises a single microlens 300 for concentrating, e.g., focusing, of light, through a transparent planarization layer 72 and optionally a color filter 71, onto a photodiode 200 of the regular pixel 100.

Each microlens 3, 30, 300 of a particular pixel 1, 10, 100 may ensure that light incident on the microlens 3, 30, 300 propagates to the photodiode 2, 20, 200 of that particular pixel 1, 10, 100, thereby preventing light from propagating to adjacent pixels 1, 10, 100. Furthermore, as described in the background to the invention, preferably, the microlenses 3, 30 of the phase detection autofocus pixels 1, 10 focus light having a particular angle of incidence, in the plane of the light shields 4, 40. In other words, preferably, the microlenses 3, 30 of the phase detection autofocus pixels 1, 10 have a focal length that is substantially equal to the distance between the microlens 3, 30 and the light shield 4, 40 associated therewith.

Although each of the regular pixels 100 comprises, in the example illustrated, a single microlens 300, alternatively, each of the regular pixels 100 may comprise a plurality, for instance a regular array of, e.g., four, microlenses as well. The number and ordering of microlenses may be the same as or different from the number and ordering of the microlenses of the autofocus pixels. The microlenses of the regular pixels 100 may have substantially the same shape and size as the microlenses 3, 30 of the phase detection autofocus pixels 1, 10. This may facilitate manufacturing of the image sensor 6.

The color filter 71 may block light that is unwanted to be detected, e.g., light that is not in the visible spectrum but that would unwantedly result in the generation of a signal by the photodiode 2, 20, 200, from reaching the photodiode 2, 20, 200. Furthermore, the color filter 71 may allow only a limited part of the visible spectrum, e.g., red or blue or green, to pass. For example, different regular pixels 100 may have a different color filter 71 for allowing a different part of the visible spectrum to pass, so that the regular pixel 100 may be used as a color pixel.

The transparent planarization layer 72 may provide a uniform, planar top surface 70 on which the microlens 3, 30, 300 is formed. Thereby, the bottom surface of the microlens 3, 30, 300 may be substantially planar, facilitating good focusing by the microlens 3, 30, 300.

In this example, each microlens 3, 30, 300 has the shape of a cuboid with rounded corners. However, the microlenses 3, 30, 300 may have any shape, e.g., each microlens 3, 30, 300 may be a spherical lens.

Each microlens 3 of the first phase detection autofocus pixel 1 is associated with a light shield 4 for blocking part of the light transmitted by the microlens 3 towards the photodiode 2 of the first phase detection autofocus pixel 1. Herein, the light shields 4 of the first phase detection autofocus pixel 1 are offset by a distance d from an optical axis 31 of their associated microlenses 3 in a same, first offset direction X. In the example illustrated, the light shield 4 associated with a microlens 3 of the first phase detection autofocus pixel 1 blocks substantially all light transmitted by the associated microlens 3 that would, in absence of the light shield 4, be collected by the photodiode 2 at a side of said optical axis 31 in the first offset direction X. Similarly, each microlens 30 of the second phase detection autofocus pixel 10 is associated with a light shield 40 for blocking part of the light transmitted by the microlens 30 towards the photodiode 20 of the second phase detection autofocus pixel 10. Herein, the light shields 40 are offset by a distance d from an optical axis 310 of their associated microlenses 30 in a same, second offset direction -X that is opposite to the first offset direction X. In the example illustrated, the light shield 40 associated with a microlens 30 of the second phase detection autofocus pixel 10 blocks substantially all light transmitted by the associated microlens 30 that would, in absence of the light shield 40, be collected by the photodiode 20 at a side of said optical axis 310 in the second offset direction -X. As may be observed in FIG. 5 and FIG. 6, in the example illustrated, each light shield 4, 40 covers the complete part of the photodiode 1, 10 overlapping with a halve of the associated microlens 3, 30 at a side of the optical axis 31, 310 of the associated microlens 3, 30 in the respective offset direction X, -X, while exposing the rest of the photodiode 1, 10. In the embodiment illustrated in FIG. 5 and FIG. 6, all light shields have the same width. This is not necessarily the case. For PDAF pixels in the center of the image sensor, their width should be the same; while for pixels closer to the edge of the imager, the width can be different.

In the example illustrated, each of the light shields 4, 40 has substantially the same shape and size. The light shields 4, 40 are offset by substantially a same distance d from the optical axis 31, 310 of their associated microlens 3, 30. Herein, the distance d may be that between a center of the light shield 4, 40 to the optical axis 31, 310 of their associated microlens 3, 30. The light shields 4, 40 are, furthermore, located at a same distance from the associated microlens 3, 30. Although, in FIG. 5, the light shields 4, 40 are shown to be separate from each other, that is not required. For example, light shields 4, 40 that are in physical contact with each other may, instead, be integral with each other, which may facilitate manufacturing.

Although, in the example illustrated, the light shields 4, 40 are offset in a direction along X, said offset may be in any horizontal direction, that is, any direction in the plane of the image sensor 6, i.e., in the plane perpendicular to the optical axes 31, 310. For example, alternatively, said offset could be along a direction Y perpendicular to X. In that case, the light shields 4, 40 would be typically rotated in the X, Y-plane by 90°. An image sensor may comprise a first pair of phase detection autofocus pixels 1, 10 comprising light shields 4, 40 offset along the direction X, and a second pair of phase detection autofocus pixels comprising light shield offset along the direction Y, perpendicular to X. This may improve the focusing accuracy. Furthermore, in yet other embodiments, a third pair of PDAF pixels can have their light shield rotated in the X,Y-plane at 45° compared to the orientation of light shields of first or second pair of PDAF pixels. In yet alternative embodiments, also other rotation angles for the light shields of some of the PDAF pixel pairs can be implemented.

In the embodiment illustrated in FIG. 6, the phase detection autofocus pixels 1, 10 - just like the regular pixels 100 - have a color filter. It is to be noted that, if color filters are used in the phase detection autofocus pixels, the PDAF pixel pairs have the same color filter (e.g. R, or G, or B).

In a third aspect, the present invention relates to a camera comprising the image sensor in accordance with embodiments of the second aspect of the present invention comprising the device configured for comparing a signal generated by the photodiode of the first phase detection autofocus pixel with a signal generated by the photodiode of the second phase detection autofocus pixel. The camera further comprises a camera lens. The camera is configured for moving the camera lens along an optical axis of the camera lens based on said comparing of a signal generated by the photodiode of the first phase detection autofocus pixel with a signal generated by the photodiode of the second phase detection autofocus pixel.

Typically, a camera in accordance with embodiments of the present invention may function similarly, and have similar features, as cameras of the state of the art, except for each phase detection autofocus pixel in accordance with embodiments of the present invention containing more than one microlens, and a light shield associated with each microlens, instead of the single microlens and a light shield associated therewith for phase detection autofocus pixels of the state of the art.

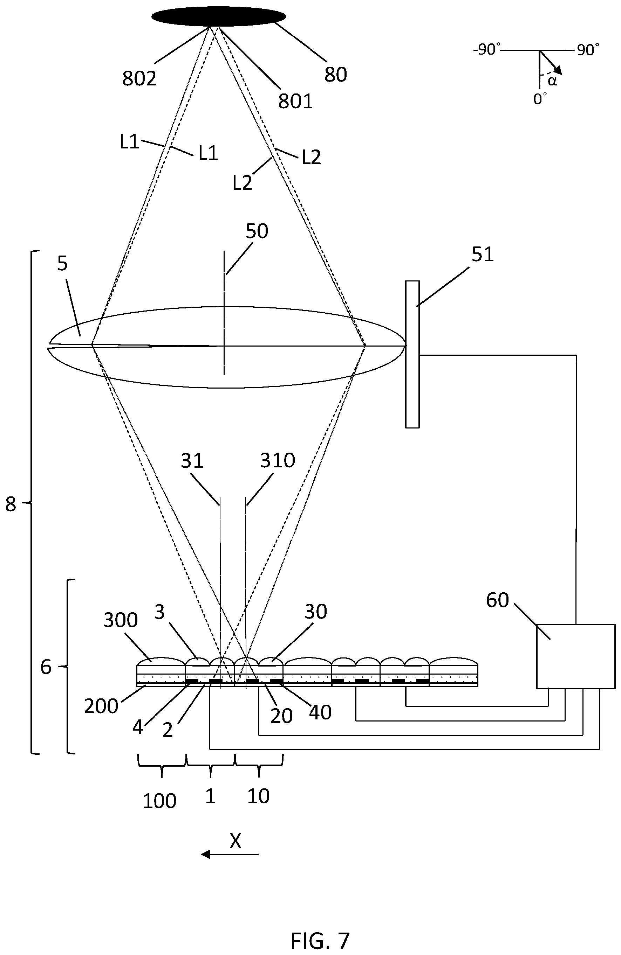

Reference is made to FIG. 7, which illustrates a camera 8 in accordance with embodiments of the present invention. The camera 8 comprises an image sensor 6, of which only a part is shown. The image sensor 6 contains a plurality of pairs of phase detection autofocus pixels 1, 10.

The image sensor 6 comprises a comparison device 60 configured for comparing signals (e.g., a first image) generated by the photodiode 2 of the first phase detection autofocus pixels 1 with signals (e.g., a second image) generated by the photodiode 20 of the second phase detection autofocus pixels 10 of the plurality of pairs of phase detection autofocus pixels 1, 10. Specifically, the comparison device 60 is communicatively coupled to the photodiode 2 of each first phase detection autofocus pixel 1 and to the photodiode 20 of each second phase detection autofocus pixel 10 for receiving signals from the photodiodes 2, 20 of the phase detection autofocus pixels 1, 10. Herein, the signal generated within each photodiode 2, 20 is assumed to be proportional to the amount of light incident on the photodiode 2, 20. Said comparison device 60 may comprise a processor for performing said comparison.

The camera 8, furthermore, comprises a collection device (not shown) for collecting signals generated by the photodiodes 200 of regular pixels 100. The comparison device 60 for said comparing and the collection device for collecting signals generated by the photodiodes 200 of regular pixels 100 may be the same device, e.g., the same processor, or they may be different devices, e.g., different processors.

The camera 8 further comprises a camera lens 5. Similarly as in the prior art and as described elsewhere in the description, the signals from the first phase detection autofocus pixels 1 and the second phase detection autofocus pixels 10 may be compared by the comparison device 60, and the comparison device 60 may induce an actuator 51 to move the camera lens 5 along an optical axis 50 of the camera lens 5 based on said comparison. Specifically, partially repeating the explanation in the background of the invention, light from each point 801, 802 on an object 80 may be assumed to be split into a first light beam L1 and a second light beam L2, propagating through different halves of the camera lens 5.

When the camera 8 is said to be in focus with respect to the object 80, as is the case in FIG. 7, the light collected by the camera lens 5 from each specific point 801, 802 on said object 80 is focused in the plane of the microlenses 3, 30, 300. As such, a sharp image of the object 80 is projected by the camera lens 5 onto the image sensor 6.

For simplicity, in FIG. 7, the propagation paths of the light beams L1, L2 from two different, neighboring points 801 and 802 on the object 80 are shown. Similarly as for phase detection autofocus pixels of the prior art, in the ideal case with optimal focussing capabilities of the microlenses, when the camera 8 is in focus, for light beams L1, L2 focused onto a microlens 3 of one of the first phase detection autofocus pixels 1 (e.g., the light beams L1, L2 from the first point 801), the first light beam L1 is detected by the photodiode 2 of the first phase detection autofocus pixel 1, while the light shield 4 associated with the microlens 3 blocks the second light beam L2. For light beams L1, L2 focused onto a microlens 3 of one of the second phase detection autofocus pixels 10 (e.g., the light beams L1, L2 from the second point 802), the second light beam L2 is detected by the photodiode 20 of the second phase detection autofocus pixel 10, while the light shield 40 associated with the microlens 30 blocks the first light beam L1.

As a result, when the camera 8 is in focus, a first image of the object 80 generated by the first phase detection autofocus pixels 1 has a pre-defined offset compared to a second image of the object generated by the second phase detection autofocus pixels 10. This pre-defined offset takes into account the physical shift between the two centers of the PDAF pixel pairs.

When, instead, the camera 8 is out of focus with respect to said object 80, the first light beams L1 and the second light beams L2 from each point 801, 802 on the object 80 are focused at a point away from the plane of the microlenses 3, 30, 300, so that the first and second light beam L1, L2 from each point 801, 802 on the object 80 are incident on different pixels 1, 10, 100. As a result, similarly as shown in FIG. 3 and explained in the background of the invention, the first image ("S1 image") produced by the first phase detection autofocus pixels 1 detecting the first light beams L1 and the second image ("S2 image") produced by the second phase detection autofocus pixels 10 detecting the second light beams L2 would be shifted more than the pre-defined offset with respect to each other. When the camera 8 is out of focus, the camera lens 5 may be moved by the actuator 51 so as to overlap the first and second image, thereby bringing the camera 8 in focus. With reference to FIG. 3, if the S1 image comes before the S2 image, a rear focus situation occurs; and if the S2 image comes before the S1 image (not illustrated) a front focus situation occurs. Depending on which situation occurs, the actuator can decide in which direction the camera lens has to be moved to obtain focus.

The inset in the top right corner indicates the orientation of the angle of incidence α for light incident on the microlenses 3, 30. Herein, the angle of incidence α is in a plane parallel to the optical axes 31, 310 of the microlenses 3, 30 and the X-axis, and is with respect to normal incidence, i.e., along the optical axes 31, 310 of the microlenses 3, 30. Herein, a direction for incident light that has an X-component pointing in the direction of X has a negative angle of incidence α, and a direction of incident light that has an X-component pointing in the direction of -X has a positive angle of incidence α.

The above described idealized functioning implies a perfect selectivity of the first phase detection autofocus pixels 1 towards the first light beams L1 and of the second phase detection pixels 10 towards the second light beams L2. This is achieved when for the first phase detection autofocus pixels 1, in the example illustrated, all light incident on each microlens 3 of each first phase detection autofocus pixel 1 at an angle α smaller than 0° (i.e., the second light beams L2), is blocked by the light shield 4 associated with the microlens 3, while all light incident on the microlens 3 at an angle α larger than 0° (i.e., the first light beams L1) is detected by the photodiode 2 of the first phase detection autofocus pixel 1. Similarly, for the second phase detection autofocus pixels 10, in the example illustrated, this perfect selectivity is achieved when all light incident on each microlens 30 of each second phase detection autofocus pixel 10 at an angle α larger than 0° is blocked by the light shield 40 associated with the microlens 30, while all light incident on the microlens 30 at an angle α smaller than 0° is detected by the photodiode 20 of the second phase detection autofocus pixel 10.

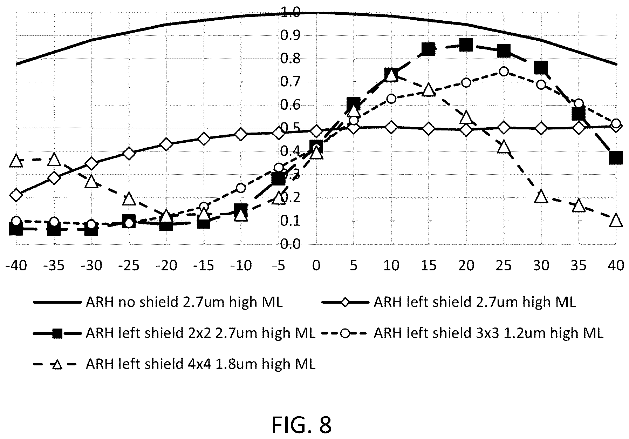

Reference is made to FIG. 8, which is a plot of a modelled quantum efficiency, as a function of angle of incidence α, for different, large first phase detection autofocus pixels, wherein the photodiodes of the different pixels are of equal size. The simulation data was obtained through TCAD simulations (Ansys Lumerical optoelectronic device simulator). The curve annotated with diamonds is the angular dependent quantum efficiency of a large first phase detection autofocus pixel containing, in accordance with the state of the art, only a single microlens, having a height of 2.7µm, and a single light shield associated therewith. Due to the large size (7.2 µm for the pixel in the simulation) of the phase detection autofocus pixel of the state of the art, forming the components of the pixel has been performed at the edge of the processing capabilities. For example, the shape of the microlens is particularly poor, as the height and radius of curvature of the microlens are, in this case, so large that known manufacturing techniques do not result in well-formed microlenses. As a result, focusing of light of each angle of incidence by the microlens in the plane of the light shields is poor. Indeed, as is clear from FIG. 8, light incident at an angle of incidence α below zero is not at all efficiently blocked by the light shield of the first phase detection autofocus pixel in accordance with the state of the art, compared with light incident at an angle of incidence α above zero. This poor selectivity would result in a poor contrast between the first and second image generated by such large first and second phase detection autofocus pixels of the state of the art, thus resulting in a poor autofocus functionality.

For comparison, the plain curve shows the angular dependent quantum efficiency for a regular pixel, having a single microlens having a height of 2.7µm, not comprising a light shield. Therefore, the regular pixel is equally sensitive to light having a positive angle of incidence as to light have a negative angle of incidence, or in other words, does not exhibit any selectivity.

In FIG. 8, the curve annotated with black squares corresponds to a large phase detection autofocus pixel (7.2 µm width) in accordance with embodiments of the present invention, comprising an array of 2x2 microlenses each having a height of 2.7µm, and each microlens having an associated light shield blocking all light propagating through the microlens towards a part of the photodiode of the phase detection autofocus pixel in a first direction of the optical axis of the microlens. It is to be noted that the single microlens and the array of 2x2 microlenses used in the different simulations have the same thickness of 2.7 µm. The same thickness of the microlens on a smaller pitch results in a larger curvature of the microlens, and therefore higher focussing capability, such that the smaller microlenses succeed better in focussing the light at the light shield (for a given planarization and color filter thickness). The curve annotated with triangles shows the situation for a similar phase detection autofocus pixel in accordance with embodiments of the present invention, but having 4x4 microlenses (with associated light shields), each microlens having a height of 1.8µm. The curve annotated with circles shows the situation for a similar phase detection autofocus pixel in accordance with embodiments of the present invention, but having 3x3 microlenses (with associated light shields), each microlens having a height of 1.2µm. It may be observed that each of the exemplary first phase detection autofocus pixels in accordance with embodiments of the present invention has a very good selectivity towards light beams having a positive angle of incidence α, wherein almost all light having a negative angle of incidence α is blocked by the light shields and a good signal is obtained from light having a positive angle of incidence α.

Thus, when using, in accordance with embodiments of the present invention, phase detection autofocus pixels, each comprising a plurality of microlenses, each microlens having a light shield associated therewith, even in the case of large pixels and correspondingly large photodiodes, the processing steps that are used for forming the microlenses and the optical stack may be performed in a range for which they have been optimized. Therefore, also for image sensors containing large pixels, and thus large phase detection autofocus pixels, good focusing of light of each angle of incidence by the microlenses in the plane of the light shields may be obtained, so that the selectivity, and thus the autofocus functionality, may be good.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A phase detection autofocus pixel (1) comprising,
a photodiode (2),
a plurality of microlenses (3) for concentrating light, incident on each of the microlenses (3), onto the photodiode (2), and
for each microlens (3), a light shield (4) associated therewith, for blocking part of the light transmitted by the microlens (3) towards the photodiode (2), **characterised in that** the light shields (4) are offset from an optical axis (31) of their associated microlenses (3) in a same offset direction (X).

2. The phase detection autofocus pixel (1) in accordance with claim 1, wherein the plurality of microlenses (3) are organised in a square array.

3. The phase detection autofocus pixel (1) in accordance with claim 2, wherein the square array of microlenses (3) comprises rows and columns of microlenses, each row (32) and column (33) comprising at least two microlenses (3).

4. The phase detection autofocus pixel (1) in accordance with any of the previous claims, wherein the plurality of microlenses (3) are substantially uniform in shape and size.

5. The phase detection autofocus pixel (1) in accordance with any of the previous claims, wherein the light shield (4) associated with a microlens (3) blocks substantially all light transmitted by the associated microlens (3) that would, in absence of the microlens (3), be collected by the photodiode (2) at a side of said optical axis (31) in said offset direction (X).

6. The phase detection autofocus pixel (1) in accordance with any of the previous claims, wherein each light shield (4) is formed of a metal.

7. The phase detection autofocus pixel (1) in accordance with any of the previous claims, wherein the light shields (4) have substantially the same dimensions, and wherein the light shields (4) are offset by substantially a same distance from the optical axis (31) of their associated microlens (3).

8. An image sensor (6) comprising a pair of phase detection autofocus pixels (1, 10) comprising:
a first phase detection autofocus pixel (1) in accordance with any of the previous claims, wherein the light shields (4) of the first phase detection autofocus pixel (1) are each offset from the optical axis (31) of their associated microlens (3) in a first offset direction (X), and a second phase detection autofocus pixel (10) in accordance with any of the previous claims, wherein the light shields (40) of the second phase detection autofocus pixel (10) are each offset from the optical axis (310) of their associated microlens (30) in a second offset direction (-X), substantially opposite to the first offset direction (X).

9. The image sensor (6) in accordance with claim 8, comprising a device (60) configured for comparing a signal generated by the photodiode (2) of the first phase detection autofocus pixel (1) with a signal generated by the photodiode (20) of the second phase detection autofocus pixel (10).

10. A camera (8) comprising the image sensor (6) in accordance with claim 9, further comprising a camera lens (5),
wherein the camera is configured for moving the camera lens (5) along an optical axis (50) of the camera lens (5) based on said comparing of a signal generated by the photodiode (2) of the first phase detection autofocus pixel (1) with a signal generated by the photodiode (20) of the second phase detection autofocus pixel (10).

11. Use of a phase detection autofocus pixel (1) in accordance with any of claims 1 to 7 for focusing of a camera lens (5).

## Patentansprüche

1. Ein Phasendetektions-Autofokuspixel (1), umfassend
eine Fotodiode (2),
eine Vielzahl von Mikrolinsen (3) zum Konzentrieren von Licht, das auf jede der Mikrolinsen (3) einfällt, auf die Fotodiode (2), und
für jede Mikrolinse (3) eine dieser zugeordneten Lichtschirmung (4) zum Blockieren eines Teils des von der Mikrolinse (3) in Richtung der Fotodiode (2) durchgelassenen Lichts, **dadurch gekennzeichnet, dass** die Lichtschirmungen (4) von einer optischen Achse (31) der dieser zugeordneten Mikrolinsen (3) in einer gleichen Versatzrichtung (X) versetzt sind.

2. Das Phasendetektions-Autofokuspixel (1) nach Anspruch 1, wobei die Vielzahl von Mikrolinsen (3) in einer quadratischen Anordnung organisiert sind.

3. Das Phasendetektions-Autofokuspixel (1) nach Anspruch 2, wobei die quadratische Anordnung von Mikrolinsen (3) Reihen und Spalten von Mikrolinsen umfasst, wobei jede Reihe (32) und Spalte (33) mindestens zwei Mikrolinsen (3) umfasst.

4. Das Phasendetektions-Autofokuspixel (1) nach einem der vorstehenden Ansprüche, wobei die Vielzahl der Mikrolinsen (3) im Wesentlichen in Form und Größe einheitlich sind.

5. Das Phasendetektions-Autofokuspixel (1) nach einem der vorstehenden Ansprüche, wobei die einer Mikrolinse (3) zugeordnete Lichtschirmung (4) im Wesentlichen das gesamte von der zugeordneten Mikrolinse (3) durchgelassene Licht blockiert, das in Abwesenheit der Mikrolinse (3) von der Fotodiode (2) auf einer Seite der optischen Achse (31) in der Versatzrichtung (X) gesammelt würde.

6. Das Phasendetektions-Autofokuspixel (1) nach einem der vorstehenden Ansprüche, wobei jede Lichtschirmung (4) aus Metall gebildet ist.

7. Das Phasendetektions-Autofokuspixel (1) nach einem der vorstehenden Ansprüche, wobei die Lichtschirmungen (4) im Wesentlichen die gleichen Abmessungen aufweisen und wobei die Lichtschirmungen (4) im Wesentlichen um den gleichen Abstand von der optischen Achse (31) ihrer zugeordneten Mikrolinse (3) versetzt sind.

8. Ein Bildsensor (6), der ein Paar von Phasendetektions-Autofokuspixeln (1, 10) umfasst, umfassend:
ein erstes Phasendetektions-Autofokuspixel (1) nach einem der vorstehenden Ansprüche, wobei die Lichtschirmungen (4) des ersten Phasendetektions-Autofokuspixels (1) jeweils von der optischen Achse (31) ihrer zugeordneten Mikrolinse (3) in einer ersten Versatzrichtung (X) versetzt sind, und
ein zweites Phasendetektions-Autofokuspixel (10) nach einem der vorstehenden Ansprüche, wobei die Lichtschirmungen (40) des zweiten Phasendetektions-Autofokuspixels (10) jeweils von der optischen Achse (310) ihrer zugeordneten Mikrolinse (30) in einer zweiten Versatzrichtung (-X) versetzt sind, die im Wesentlichen entgegengesetzt zur ersten Versatzrichtung (X) ist.

9. Der Bildsensor (6) nach Anspruch 8, der eine Vorrichtung (60) umfasst, die zum Vergleichen eines von der Fotodiode (2) des ersten Phasendetektions-Autofokuspixels (1) erzeugten Signals mit einem von der Fotodiode (20) des zweiten Phasendetektions-Autofokuspixels (10) erzeugten Signal konfiguriert ist.

10. Eine Kamera (8), die den Bildsensor (6) nach Anspruch 9 umfasst, die weiter ein Kameraobjektiv (5) umfasst,
wobei die Kamera zum Bewegen des Kameraobjektivs (5) entlang einer optischen Achse (50) des Kameraobjektivs (5) basierend auf dem Vergleich eines von der Fotodiode (2) des ersten Phasendetektions-Autofokuspixels (1) erzeugten Signals mit einem von der Fotodiode (20) des zweiten Phasendetektions-Autofokuspixels (10) erzeugten Signal konfiguriert ist.

11. Verwendung eines Phasendetektions-Autofokuspixels (1) nach einem der Ansprüche 1 bis 7 zum Fokussieren eines Kameraobjektivs (5).

## Revendications

1. Un pixel autofocus à détection de phase (1) comprenant,
une photodiode (2),
une pluralité de microlentilles (3) pour concentrer la lumière, incidente sur chacune des microlentilles (3), sur la photodiode (2), et
pour chaque microlentille (3), un écran de lumière (4) associé à celle-ci, pour bloquer une partie de la lumière transmise par la microlentille (3) vers la photodiode (2), **caractérisé en ce que** les écrans de lumière (4) sont décalés par rapport à un axe optique (31) de leurs microlentilles associées (3) dans une même direction de décalage (X).

2. Le pixel autofocus à détection de phase (1) selon la revendication 1, dans lequel la pluralité de microlentilles (3) est organisée en un réseau carré.

3. Le pixel autofocus à détection de phase (1) selon la revendication 2, dans lequel le réseau carré de microlentilles (3) comprend des rangées et des colonnes de microlentilles, chaque rangée (32) et colonne (33) comprenant au moins deux microlentilles (3).

4. Le pixel autofocus à détection de phase (1) selon l'une quelconque des revendications précédentes, dans lequel la pluralité de microlentilles (3) est sensiblement uniforme en forme et en taille.

5. Le pixel autofocus à détection de phase (1) selon l'une quelconque des revendications précédentes, dans lequel l'écran de lumière (4) associé à une microlentille (3) bloque sensiblement toute la lumière transmise par la microlentille associée (3) qui, en l'absence de la microlentille (3), serait collectée par la photodiode (2) d'un côté dudit axe optique (31) dans ladite direction de décalage (X).

6. Le pixel autofocus à détection de phase (1) selon l'une quelconque des revendications précédentes, dans lequel chaque écran de lumière (4) est formé d'un métal.

7. Le pixel autofocus à détection de phase (1) selon l'une quelconque des revendications précédentes, dans lequel les écrans de lumière (4) ont sensiblement les mêmes dimensions, et dans lequel les écrans de lumière (4) sont décalés d'une distance sensiblement égale par rapport à l'axe optique (31) de leur microlentille associée (3).

8. Un capteur d'image (6) comprenant une paire de pixels autofocus à détection de phase (1, 10) comprenant :
un premier pixel autofocus à détection de phase (1) selon l'une quelconque des revendications précédentes, dans lequel les écrans de lumière (4) du premier pixel autofocus à détection de phase (1) sont chacun décalés par rapport à l'axe optique (31) de leur microlentille associée (3) dans une première direction de décalage (X), et
un second pixel autofocus à détection de phase (10) selon l'une quelconque des revendications précédentes, dans lequel les écrans de lumière (40) du second pixel autofocus à détection de phase (10) sont chacun décalés par rapport à l'axe optique (310) de leur microlentille associée (30) dans une seconde direction de décalage (-X), sensiblement opposée à la première direction de décalage (X).

9. Le capteur d'image (6) selon la revendication 8, comprenant un dispositif (60) configuré pour comparer un signal généré par la photodiode (2) du premier pixel autofocus à détection de phase (1) avec un signal généré par la photodiode (20) du second pixel autofocus à détection de phase (10).

10. Une caméra (8) comprenant le capteur d'image (6) selon la revendication 9, comprenant en outre une lentille de caméra (5),
dans laquelle la caméra est configurée pour déplacer la lentille de caméra (5) le long d'un axe optique (50) de la lentille de caméra (5) sur la base dudit comparatif d'un signal généré par la photodiode (2) du premier pixel autofocus à détection de phase (1) avec un signal généré par la photodiode (20) du second pixel autofocus à détection de phase (10).

11. Utilisation d'un pixel autofocus à détection de phase (1) selon l'une quelconque des revendications 1 à 7 pour la mise au point d'une lentille de caméra (5).
